# EUROPÄISCHE PATENTSCHRIFT

(11) **EP 1 259 832 B1**
(45) Veröffentlichungstag und Bekanntmachung des Hinweises auf die Patenterteilung: **03.05.2006**
(21) Anmeldenummer: 01905743.9
(22) Anmeldetag: 07.02.2001
(51) Int. Cl.: G01R 33/09

(54) **MAGNETFELDMESSANORDNUNG MITTELS EINER BRÜCKENSCHALTUNG VON SPIN-TUNNEL-ELEMENTEN UND HERSTELLUNGSVERFAHREN**
ASSEMBLY FOR MEASURING A MAGNETIC FIELD, USING A BRIDGE CIRCUIT OF SPIN TUNNEL ELEMENTS AND A PRODUCTION METHOD FOR THE SAME
DISPOSITIF DE MESURE DE CHAMP MAGNETIQUE A MONTAGE EN PONT D'ELEMENTS DE TUNNEL DE SPIN, ET PROCEDE DE FABRICATION

(30) Priorität: 02.03.2000 DE 10009944
(43) Veröffentlichungstag der Anmeldung: 27.11.2002
(73) Patentinhaber: Forschungszentrum Jülich GmbH, 52425 Jülich (DE)
(72) Erfinder: KOHLSTEDT, Hermann, 50170 Kerpen (DE)
(74) Vertreter: Paul, Dieter-Alfred
(86) Internationale Anmeldenummer: PCT/EP2001/001305
(87) Internationale Veröffentlichungsnummer: WO 2001/065269

(56) Entgegenhaltungen:
- EP-A- 0 953 849
- WO-A-00/10023

## Beschreibung

Die Erfindung betrifft eine Anordnung zum Messen eines Magnetfeldes mit mindestens einer ersten Schichtanordnung und mindestens einer zweiten Schichtanordnung, wobei die erste Schichtanordnung und die zweite Schichtanordnung eine hartmagnetische Schicht, eine an die hartmagnetische Schicht angrenzende als Tunnelbarriere wirkende Schicht und eine an die als Tunnelbarriere wirkende Schicht angrenzende weichmagnetische Schicht aufweisen und wobei die Schichtanordnungen in einer Brückenschaltung zum Bestimmen des elektrischen Widerstandes angeordnet sind. Die Erfindung betrifft ferner ein Verfahren zum Herstellen einer Anordnung zum Messen eines Magnetfeldes, bei dem mindestens eine erste Schichtanordnung und mindestens eine zweite Schichtanordnung hergestellt werden, wobei die erste Schichtanordnung und die zweite Schichtanordnung eine hartmagnetische Schicht, eine an die hartmagnetische Schicht angrenzende als Tunnelbarriere wirkende Schicht und eine an die als Tunnelbarriere wirkende Schicht angrenzende weichmagnetische Schicht aufweisen.

Eine gattungsgemäße Anordnung und ein gattungsgemäßes Verfahren sind bekannt. In der Veröffentlichung INFO PHYS TECH Nr. 24/Oktober 1999, BMBF, VDI-Technologiezentrum Physikalische Technologien ist beschrieben, wie derartige Anordnungen zum Messen von Magnetfeldern verwendet werden können. Ein bevorzugtes Einsatzgebiet ist beispielsweise die Erkennung und die Vermessung von Bewegungen, was etwa in der Automobiltechnik und in der Automatisierungstechnik von großer Bedeutung ist. Herkömmlich werden für diese "Positionssensorik" Hallsensoren verwendet (etwa ABS-Sensoren im Automobil). Ein neues Sensorkonzept nutzt den sogenannten Riesenmagnetowiderstandseffekt (GMR-Effekt "giant magnetoresistance"). Dieser Effekt beruht darauf, daß Elektronen aufgrund ihrer quantisierten Spinzustände beim Durchgang durch magnetische Schichten je nach Ausrichtung der Magnetisierung dieser Schichten unterschiedlich stark gestreut werden. Bei paralleler Magnetisierung ist die Streuung geringer als bei antiparallel angeordneter Magnetisierung. Dies führt zu einer Änderung des elektrischen widerstandes in Abhängigkeit des äußeren Magnetfeldes, in welchem sich die Schichtanordnung befindet. Die Bedeutung für die Positionssensorik ergibt sich nun daraus, daß ein äußeres Magnetfeld von einem beweglichen Element (etwa einem Rotor oder auch einem sich geradlinig bewegenden Element) beeinflußt wird, wobei sich diese Beeinflussung im elektrischen Widerstand der Schichtanordnung zeigt.

Grundsätzlich ist der Schichtaufbau so zu wählen, daß eine magnetische Schicht als Meßschicht und eine andere magnetische Schicht als Referenzschicht ausgelegt ist. Bei einer Anordnung, die auf dem GMR-Effekt beruht, ist die Zwischenschicht zwischen diesen magnetischen Schichten eine Metallschicht. Ersetzt man in dem Schichtaufbau die metallische Zwischenschicht durch eine dünne, elektrisch isolierende Schicht, wie z.B. Al₂O₃, so erhält man ein magnetisches Tunnelbauelement, in dem sich der Tunnelstrom in ähnlicher Weise schalten läßt, wie der Strom in den metallischen GMR-Elementen. Der Vorteil der TMR-Elemente besteht in einem noch größeren Signalhub und in einem extrem geringen Bedarf an aktiver Bauelementfläche.

Es sind hohe Anforderungen an die Messung des Widerstandes der Schichtanordnungen zu stellen, da der Widerstand die entscheidende Größe für den Rückschluß auf den Betrag und/oder die Richtung des zu vermessenden Magnetfeldes ist. Es ist bekannt, daß sich Widerstände besonders genau mit einer Wheatstone-Brückenschaltung vermessen lassen. Dies ist hauptsächlich in der erforderlichen Temperaturkompensation begründet. Zusätzlich steht bei einer Wheatstone-Brücke eine um den Nullpunkt symmetrische Ausgangsspannung zur Verfügung. Bei der Auslegung einer Wheatstone-Brücke kommt es im Hinblick auf die Qualität der Messung entscheidend auf die Genauigkeit der eingesetzten Widerstände an. Festwiderstände sind praktisch beliebig genau bestimmbar. Setzt man aber in der Brückenschaltung mehrere Schichtanordnungen ein, so sind auch deren elektrische widerstände genau zu bestimmen bzw. festzulegen.

Der Erfindung liegt daher die **Aufgabe** zugrunde, eine Anordnung zum Messen eines Magnetfeldes und ein Herstellungsverfahren anzugeben, so daß die elektrischen Eigenschaften der an der Messung beteiligten Elemente genau bekannt bzw. festgelegt sind.

Diese Aufgabe wird mit den Merkmalen der Ansprüche 1 und 12 gelöst.

Die Erfindung baut auf der gattungsgemäßen Anordnung dadurch auf, daß die zweite Schichtanordnung zusätzlich eine an die weichmagnetische Schicht angrenzende elektrisch leitende antiferromagnetische Schicht oder einen an die weichmagnetische Schicht angrenzenden elektrisch leitenden künstlichen Antiferromagneten aufweist. Auf diese Weise läßt sich die zweite Schichtanordnung, welche als Widerstand in der Wheatstone-Brückenschaltung verwendet wird, in derselben weise auslegen, wie die erste Schichtanordnung. Durch die zusätzliche elektrisch leitende antiferromagnetische Schicht wird die zweite Schichtanordnung magnetisch unempfindlich. Ein solches "Pinnen" der zweiten Schichtanordnung hat im Vergleich zu einer magnetischen Abschirmung erhebliche Vorteile. Letztere, welche auch zum Herabsetzen der magnetischen Empfindlichkeit verwendet werden kann, macht die Ablagerung dicker hoch-µ-Schichten im Mikrometerbereich erforderlich. Dies hat erhebliche Nachteile bei der Herstellung der Bauelemente.

Vorzugsweise ist die Brückenschaltung eine Wheatstone-Brückenschaltung.

Bei einer Ausführungsform der Erfindung sind die vier Widerstände der Wheatstone-Brückenschaltung als erste oder zweite Schichtanordnungen ausgelegt, wobei mindestens eine Schichtanordnung als zweite Schichtanordnung ausgelegt ist. Bei einer derartigen "Vollbrücke" läßt sich ein großer Hub im Meßsignal erzeugen.

Bei einer anderen Ausführungsform ist ein widerstand der Wheatstone-Brücke als erste Schichtanordnung ausgelegt, ein widerstand der Wheatstone-Brücke ist als zweite Schichtanordnung ausgelegt, und zwei Widerstände der Wheatstone-Brücke sind als Festwiderstände ausgelegt. Da die beiden Festwiderstände nicht zum Brückenausgangssignal der "Halbbrücke" beitragen, reduziert sich zwar der erreichbare Hub der Brücke, doch kann mit den genauer auswählbaren Festwiderständen eine bessere Reduzierung des Offsets (Signalspannung ohne angelegtes Feld, bedingt durch widerstandsschwankungen über den Wafer) der Brücke erreicht werden.

Obwohl dies im Zusammenhang mit Tunnelkontakten nicht problemlos zu realisieren ist, ist es denkbar, daß die hartmagnetische Schicht der Schichtanordnung eine elektrisch nichtleitende antiferromagnetische Schicht ist. Damit ließe sich eine Referenzmagnetisierung liefern, welche durch das ansteuernde äußere Magnetfeld nur wenig beeinflußt wird.

Es kann auch vorteilhaft sein, daß die hartmagnetische Schicht der Schichtanordnungen mit einer elektrisch nichtleitenden antiferromagnetischen Schicht gepinnt ist. Die hartmagnetische Schicht kann auf diese Weise so gewählt werden, daß sie beste Eigenschaften im Hinblick auf den Tunnelkontakt aufweist, während sie durch das Pinnen mit dem Antiferromagneten eine ausreichende Gegenfeldstabilität erhält und somit magnetisch wenig beeinflußbar wird.

Es kann vorteilhaft sein, daß die elektrisch nichtleitende antiferromagnetische Schicht aus NiOₓ besteht. NiOₓ ist als Nichtleiter geeignet, da in Tunnelkontakten der Stromfluß senkrecht zum Substrat verläuft.

In einer anderen Ausführungsform besteht die elektrisch nichtleitende antiferromagnetische Schicht aus einem künstlichen Antiferromagneten. Künstliche Antiferromagneten (AAF) bewirken besonders bei hohen Betriebstemperaturen eine gute Gegenfeldstabilität.

Dabei ist bevorzugt, daß der künstliche Antiferromagnet ein Schichtensystem aus Cu und Co oder Ru aufweist. Durch die geeignete Wahl der Cu-Schichtdicke wird eine Antiparallelstellung der Co- und Ru-Lagen erreicht, die nur durch sehr hohe Magnetfelder aufgehoben werden kann. Wählt man die Dicken der Co- oder Ru-Schichten zusätzlich so, daß die resultierende Magnetisierung klein ist, dann läßt sich die magnetische Vorzugsrichtung des künstlichen Antiferromagneten nur schwer in einem äußeren Magnetfeld verändern.

Vorzugsweise besteht die elektrisch leitende antiferromagnetische Schicht aus IrMn. Hierdurch wird also gleichzeitig die für die Funktion erforderliche elektrische Leitfähigkeit als auch der für das Pinnen benötigte Antiferromagnetismus bereitgestellt.

Bevorzugt besteht die Tunnelbarriere aus Al₂O₃. Eine solche Schicht ist elektrisch isolierend, und sie kann in vorteilhafter weise zur Ausbildung des Tunnelkontaktes ausgebildet werden. Die Schicht besteht vorzugsweise vollständig aus stöchiometrischem Al₂O₃. Beispielsweise ist die Schicht so herstellbar, daß auf die hartmagnetische Schicht eine dünne Al-Schicht aufgesputtert wird. Die aufgesputterte Al-Schicht wird dann für etwa 30 Minuten einer Sauerstoff-Atmosphäre von etwa 10 mbar ausgesetzt, wobei eine Quecksilber-Niederdrucklampe zur Erzeugung von UV-Strahlung eingesetzt wird. Die UV-Strahlung bewirkt, daß molekularer Sauerstoff in hochreaktiven atomaren Sauerstoff und Ozon umgesetzt wird. Die Oxidation sollte so durchgeführt werden, daß möglichst sämtliches abgelagertes Al vollständig oxidiert wird. Eine Plasmaoxidation des Al ist ebenso möglich.

Die Erfindung baut auf dem gattungsgemäßen Verfahren dadurch auf, daß die Schichtanordnungen parallel in einem einzigen Verfahren hergestellt werden und daß auf der zweiten Schichtanordnung zusätzlich eine an die weichmagnetische Schicht angrenzende elektrisch leitende antiferromagnetische Schicht oder ein an die weichmagnetische Schicht angrenzender elektrisch leitender künstlicher Antiferromagnet angeordnet wird. Durch dieses Verfahren kann also erreicht werden, daß sowohl die erste als auch die zweite Schichtanordnung gleiche Widerstände und elektrische Eigenschaften aufweisen. Damit sind sie für den Einsatz in der Wheatstone-Brückenschaltung besonders geeignet.

Vorzugsweise werden die Schichtanordnungen durch Deposition der Schichten erzeugt. Dies ist ein bewährtes Verfahren zum Erzeugen derartiger Bauelemente.

Besonders bevorzugt ist es, wenn die zusätzliche elektrisch leitende antiferromagnetische Schicht im Anschluß an die Deposition des Tunnelkontaktschichtsystems aufgebracht wird. Der Herstellungsprozeß der Schichtanordnungen kann somit ohne Unterbrechung erfolgen.

Dann werden die fertigen Schichtanordnungen vorzugsweise in einer Brückenschaltung verschaltet.

Der Erfindung liegt die überraschende Erkenntnis zugrunde, daß die Messung von Magnetfeldern durch das zusätzliche Aufbringen einer elektrisch leitenden antiferromagnetischen Schicht auf der magnetischen Schicht im Zusammenhang mit einer Brückenschaltung besonders präzise erfolgen kann. Der Grund hierfür liegt unter anderem darin, daß identische Schichtanordnungen mit identischen elektrischen Eigenschaften sowohl als Referenzelement als auch als magnetfeldempfindliches Element verwendet werden. Dies hat auch im Hinblick auf das Verfahren besondere Vorteile, da die sich bezüglich der zusätzlichen leitenden antiferromagnetischen Schicht unterscheidenden Schichtanordnungen bis dahin in demselben Herstellungsprozeß erzeugbar sind.

Die Erfindung wird nun mit Bezug auf die begleitenden Zeichnungen anhand von Ausführungsformen beispielhaft beschrieben.
- Fig. 1: zeigt eine erste Schichtanordnung für eine erfindungsgemäße Anordnung;
- Fig. 2: zeigt eine zweite Schichtanordnung für eine erfindungsgemäße Anordnung;
- Fig. 3: zeigt eine erfindungsgemäße Anordnung.

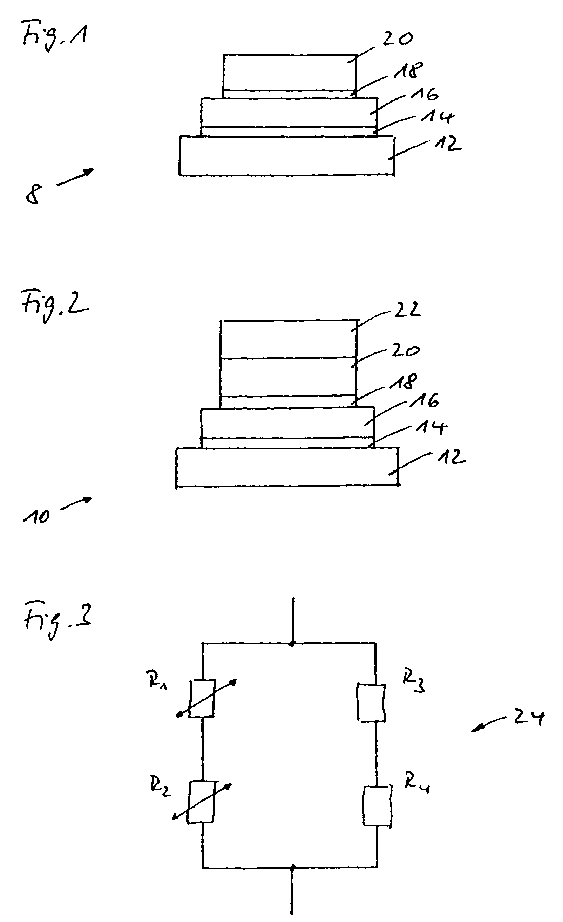

In Fig. 1 ist eine erste Schichtanordnung 8 für eine erfindungsgemäße Anordnung dargestellt. Auf einem Substrat 12 ist eine nichtleitende oder leitende antiferromagnetische Schicht 14 angeordnet, beispielsweise ein künstlicher Antiferromagnet. Diese Schicht 14 kann beispielsweise durch NiOₓ oder IrMn gebildet sein. Darauf befindet sich eine hartmagnetische Schicht 16. Dieser folgt eine als Tunnelbarriere wirkende Schicht 18, zum Beispiel aus Al₂O₃. Auf der als Tunnelbarriere wirkenden Schicht 18 ist abschließend eine weichmagnetische Schicht 20 angeordnet.

In Fig. 2 ist eine zweite Schichtanordnung 10 zur Verwendung in einer erfindungsgemäßen Anordnung dargestellt. Die Schichtenfolge ist identisch, bis darauf, daß auf der zweiten Schichtanordnung 10 zusätzlich auf der weichmagnetischen Schicht 20 eine elektrisch leitende antiferromagnetische Schicht 22, beispielsweise aus IrMn, angeordnet ist.

Bis einschließlich der weichmagnetischen Schicht 20 können die Schichtanordnungen 8, 10, gemäß den Fig. 1 und 2 also in einem einheitlichen Verfahren hergestellt werden. Dies hat verfahrenstechnische Vorteile; ferner sind die Schichtanordnungen 8, 10, bis zur Schicht 20 identisch, insbesondere im Hinblick auf ihre elektrischen Eigenschaften.

In Fig. 3 ist eine Wheatstone-Brücke 24 zur Messung der magnetfeldabhängigen Widerstände dargestellt. Im vorliegenden Fall handelt es sich um eine "Halbbrücke", das heißt die Widerstände R₃ und R₄ sind Festwiderstände, während es sich bei den Widerständen R₁ und R₂ um Schichtanordnungen handelt. Wählt man beispielsweise für den Widerstand R₁ die Schichtanordnung 8 gemäß Fig. 1 und für den Widerstand R₂ die Schichtanordnung 10 gemäß Fig. 2, welche im selben Herstellungsverfahren erzeugt wurden, so lassen sich präzise Widerstandsmessungen und somit präzise Magnetfeldmessungen durchführen.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

## Patentansprüche

1. Anordnung zum Messen eines Magnetfeldes mit
- mindestens einer ersten Schichtanordnung (8) und
- mindestens einer zweiten Schichtanordnung (10),
- wobei die erste Schichtanordnung (8) und die zweite Schichtanordnung (10) eine hartmagnetische Schicht (16), eine an die hartmagnetische Schicht angrenzende als Tunnelbarriere wirkende Schicht (18) und eine an die als Tunnelbarriere wirkende Schicht (18) angrenzende weichmagnetische Schicht (20) aufweisen und
- wobei die Schichtanordnungen (8, 10) in einer Brükkenschaltung (24) zum Bestimmen des elektrischen Widerstandes angeordnet sind,
**dadurch gekennzeichnet,**
- **daß** die zweite Schichtanordnung (10) zusätzlich eine an die weichmagnetische Schicht (20) angrenzende elektrisch leitende antiferromagnetische Schicht (22) aufweist oder einen an die weichmagnetische Schicht (20) angrenzenden elektrisch leitenden künstlichen Antiferromagneten aufweist.

2. Anordnung nach Anspruch 1,
**dadurch gekennzeichnet,**
**daß** die Brückenschaltung (24) eine Wheatstone-Brückenschaltung ist.

3. Anordnung nach Anspruch 1 oder 2,
**dadurch gekennzeichnet,**
**daß** die vier Widerstände der Wheatstone-Brückenschaltung (24) als erste Schichtanordnungen (8) oder zweite Schichtanordnungen (10) ausgelegt sind, wobei mindestens eine Schichtanordnung als zweite Schichtanordnung (10) ausgelegt ist.

4. Anordnung nach Anspruch 1 oder 2,
**dadurch gekennzeichnet,**
- **daß** ein Widerstand (R₁) der Wheatstone-Brücke als erste Schichtanordnung (8) ausgelegt ist,
- **daß** ein Widerstand (R₂) der Wheatstone-Brückenschaltung (24) als zweite Schichtanordnung (10) ausgelegt ist und
- **daß** zwei Widerstände (R₃, R₄) der Wheatstone-Brückenschaltung (24) als Festwiderstände ausgelegt sind.

5. Anordnung nach einem der vorangehenden Ansprüche,
**dadurch gekennzeichnet,**
**daß** die hartmagnetische Schicht (16) der Schichtanordnungen (8, 10) eine elektrisch nichtleitende antiferromagnetische Schicht (14) ist.

6. Anordnung nach einem der Ansprüche 1 bis 4,
**dadurch gekennzeichnet,**
**daß** die hartmagnetische Schicht (16) der Schichtanordnungen (8, 10) mit einer elektrisch nichtleitenden antiferromagnetischen Schicht (14) gepinnt ist.

7. Anordnung nach einem der vorangehenden Ansprüche,
**dadurch gekennzeichnet,**
**daß** die elektrisch nichtleitende antiferromagnetische Schicht (14) aus NiOₓ besteht.

8. Anordnung nach einem der Ansprüche 1 bis 6,
**dadurch gekennzeichnet,**
**daß** die elektrisch nichtleitende antiferromagnetische Schicht (14) aus einem künstlichen Antiferromagneten besteht.

9. Anordnung nach Anspruch 8,
**dadurch gekennzeichnet,**
**daß** der künstliche Antiferromagnet ein Schichtensystem aus Cu und Co aufweist.

10. Anordnung nach einem der vorangehenden Ansprüche,
**dadurch gekennzeichnet,**
**daß** die elektrisch leitende antiferromagnetische Schicht (22) aus IrMn besteht.

11. Anordnung nach einem der vorangehenden Ansprüche,
**dadurch gekennzeichnet,**
**daß** die als Tunnelbarriere wirkende Schicht (18) aus Al₂O₃ besteht.

12. Verfahren zum Herstellen einer Anordnung zum Messen eines Magnetfeldes, bei dem
- mindestens eine erste Schichtanordnung (8) und
- mindestens eine zweite Schichtanordnung (10) hergestellt werden,
- wobei die erste Schichtanordnung (8) und die zweite Schichtanordnung (10) durch eine hartmagnetische Schicht (16), eine an die hartmagnetische Schicht (16) angrenzende als Tunnelbarriere wirkende Schicht (18) und eine an die als Tunnelbarriere wirkende Schicht (18) angrenzende weichmagnetische Schicht (20) aufweisen,
**dadurch gekennzeichnet,**
- **daß** die Schichtanordnungen (8, 10) parallel in einem einzigen Verfahren hergestellt werden und
- **daß** auf der zweiten Schichtanordnung (10) zusätzlich eine an die weichmagnetische Schicht (20) angrenzende elektrisch leitende antiferromagnetische Schicht (22) oder ein an die weichmagnetische Schicht (20) angrenzender elektrisch leitender Antiferromagneten angeordnet wird.

13. verfahren nach Anspruch 12,
**dadurch gekennzeichnet,**
**daß** die Schichtanordnungen (8, 10) durch Ablagerung der Schichten erzeugt werden.

14. Verfahren nach Anspruch 13,
**dadurch gekennzeichnet,**
**daß** die zusätzliche elektrisch leitende antiferromagnetische Schicht (22) im Anschluß an die Ablagerung aufgebracht wird.

15. Verfahren nach Anspruch 13 oder 14,
**dadurch gekennzeichnet,**
**daß** die fertigen Schichtanordnungen (8, 10) in einer Brückenschaltung (24) verschaltet werden.

16. Verfahren nach Anspruch 12 oder 13,
**dadurch gekennzeichnet,**
- **daß** die Schichtanordnungen (8, 10) vor Fertigstellung in der Brückenschaltung (24) verschaltet werden und
- **daß** daraufhin die elektrisch leitfähige antiferromagnetische Schicht (22) auf gewünschte Elemente der Brückenschaltung (24) aufgebracht wird.

## Claims

1. An arrangement for measuring a magnetic field with
- at least one first layer assembly (8) and
- at least one second layer assembly (10),
- whereby the first layer assembly (8) and the second layer assembly (10) have a hard magnetic layer (16), a layer (18) effective as a tunnel barrier and adjacent the hard magnetic layer, and a layer (18) effective as a tunnel barrier layer adjacent the soft magnetic layer (20) and
- whereby the layer assemblies (8, 10) are arranged in a bridge circuit (24) for determining the electrical resistance,
**characterized in**
- **that** the second layer assembly (10) additionally has an electrically conductive antiferromagnetic layer (22), adjacent the soft magnetic layer (20) or an antiferromagnet or an electrically-conductive synthetic antiferromagnet is adjacent the soft magnetic layer (20).

2. The arrangement according to claim 1,
**characterized in,**
**that** the bridge circuit (24) is a Wheatstone bridge circuit.

3. The arrangement according to claim 1 or 2,
**characterized in,**
**that** each of the four resistances of the Wheatstone bridge circuit (24) is configured with a first layer assembly (8) or second layer assembly (10) whereby at least one of the layer assemblies is configured as the second layer assembly (10).

4. The arrangement according to claim 1 or 2,
**characterized in,**
- **that** one resistance (R₁) of the Wheatstone bridge is configured as the first layer assembly (8),
- a resistance (R₂) of the Wheatstone bridge circuit (24) is configured as the second layer assembly (10) and
- **that** two resistances (R₃ and R₄) of the Wheatstone bridge circuit 24 are configured as fixed resistors.

5. The arrangement according to one of the preceding claims,
**characterized in,**
**that** the hard magnetic layer (16) of the layer assemblies (8, 10) is an electrically nonconductive antiferromagnetic layer (14).

6. The arrangement according to one of claims 1 to 4,
**characterized in,**
**that** the hard magnetic layer (16) of the layer assemblies (8, 10) is penned with an electrically nonconductive antiferromagnetic layer (14).

7. The arrangement according to one of the preceding claims,
**characterized in,**
**that** the electrically nonconducting antiferromagnetic layer (14) is comprised of NiOₓ.

8. The arrangement according to one of claims 1 to 6,
**characterized in,**
**that** the electrically nonconducting antiferromagnetic layer (14) is comprised of a synthetic antiferromagnet.

9. The arrangement according to claim 8,
**characterized in,**
**that** synthetic antiferromagnet has a layer system of Cu and Co.

10. The arrangement according to one of the preceding claims,
**characterized in,**
**that** the electrically conducting antiferromagnetic layer (22) is comprised of IrMn.

11. The arrangement according to one of the preceding claims,
**characterized in,**
**that** the layer effective as a tunnel barrier (18) is comprised of Al₂O₃.

12. A method of producing an arrangement for measuring a magnetic field in which
- at least one first layer assembly (8)
- at least one second layer assembly (10) are produced, whereby the first layer assembly and the second layer assembly have a first hard magnetic layer (16),a layer (18) effective as a tunnel barrier and adjacent the hard magnetic layer (16) and a soft magnetic layer (20) adjacent the layer (18) effective as the tunnel barrier, **characterized in**
- **that** the layer assemblies (8, 10) are produced in parallel in a single process and
- **that** on the second layer assembly (10) an additional electrically conducting antiferromagnetic layer is provided on the soft magnetic layer (20) or an electrically-conducting antiferromagnet is provided on the soft magnetic layer (20).

13. The method according to claim 12,
**characterized in**
**that** the layer assemblies (8, 10) are produced by deposition of layers.

14. The method according to claim 13,
**characterized in**
**that** the additional electrically-conducting antiferromagnetic layer (22) is applied in conjunction with the deposition.

15. The method according to claim 13 or 14,
**characterized in**
**that** the applied layer assemblies (8, 10) are connected in a bridge circuit (24).

16. The method according to claim 12 or 13,
**characterized in**
**that** the layer assemblies (8, 10) before finishing are connected in the bridge circuit (24) and
**that** on them as necessary the electrically-conducting antiferromagnetic layer (22) is applied to the desired elements of the bridge circuit (24).

## Revendications

1. Ensemble pour la mesure d'un champ magnétique avec
- au moins une configuration de couches (8) du premier type et
- au moins une configuration de couches (10) du deuxième type,
- où la configuration de couches (8) du premier type et la configuration de couches (10) du deuxième type comporte une couche (16) constamment magnétique, une couche (18) qui est à proximité de la couche constamment magnétique et qui actionne comme barrière de tunnel, et une couche (20) temporairement magnétique qui est à proximité de la couche (18) qui actionne comme barrière de tunnel, et
- où les configurations de couches (8, 10) sont disposées dans un montage en pont (24) pour la détermination de la résistance électrique, **caractérisé en ce que**,
- la configuration de couches (10) du deuxième type comporte supplémentairement une couche (22) antiferromagnétique, électriquement conductrice, à proximité de la couche (20) temporairement magnétique, ou un antiferro-aimant artificiel, électriquement conducteur, à proximité de la couche (20) temporairement magnétique.

2. Ensemble selon la revendication 1, **caractérisé en ce que**, le montage en pont (24) est un montage en pont Wheatstone.

3. Ensemble selon la revendication 1 ou 2, **caractérisé en ce que**, les quatre résistances du montage en pont Wheatstone (24) sont réalisées comme des configurations de couches (8) du premier type ou des configurations de couches (10) du deuxième type, où au moins une configuration de couches est réalisée comme configuration de couches (10) du deuxième type.

4. Ensemble selon la revendication 1 ou 2, **caractérisé en ce que**,
- une résistance (R₁) du pont Wheatstone est réalisée comme configuration de couches (8) du premier type,
- une résistance (R₂) du montage en pont Wheatstone (24) est réalisée comme configuration de couches (10) du deuxième type et
- deux résistances (R₃ et R₄) du montage en pont Wheatstone sont réalisées comme des résistances fixes.

5. Ensemble selon l'une quelconque des revendications précédentes, **caractérisé en ce que**, la couche (16) constamment magnétique des configurations de couches (8, 10) est une couche (14) antiferromagnétique, électriquement non conductrice.

6. Ensemble selon l'une quelconque des revendications1 jusqu'à 4, **caractérisé en ce que**, la couche (16) constamment magnétique des configurations de couches (8, 10) est attachée à une couche (14) antiferromagnétique, électriquement non conductrice.

7. Ensemble selon l'une quelconque des revendications précédentes, **caractérisé en ce que**, la couche (14) antiferromagnétique, électriquement non conductrice, consiste dans Ni-Oₓ.

8. Ensemble selon l'une quelconque des revendications 1 jusqu'à 6, **caractérisé en ce que**, la couche (14) antiferromagnétique, électriquement non conductrice, consiste dans un antiferro-aimant artificiel.

9. Ensemble selon la revendication 8, **caractérisé en ce que**, l'antiferro-aimant artificiel comporte un système de couches en Cu et Co.

10. Ensemble selon l'une quelconque des revendications précédentes, **caractérisé en ce que**, la couche (22) antiferromagnétique, électriquement conductrice, consiste dans IrMn.

11. Ensemble selon l'une quelconque des revendications précédentes, **caractérisé en ce que**, la couche (18) qui actionne comme barrière de tunnel, consiste dans Al₂O₃.

12. Procédé pour la réalisation d'un ensemble pour là mesure d'un champ magnétique, où
- au moins une configuration de couches (8) du premier type est réalisée et
- au moins une configuration de couches (10) du deuxième type est réalisée,
- où la configuration de couches (8) du premier type et la configuration de couches (10) du deuxième type comporte une couche (16) constamment magnétique, une couche (18) qui est à proximité de la couche (16) constamment magnétique et qui actionne comme barrière de tunnel, et une couche (20) temporairement magnétique qui est à proximité de la couche (18) qui actionne comme barrière de tunnel, **caractérisé en ce que**,
- les configurations de couches (8, 10) sont réalisées parallèlement par un seul procédé et
- sur la configuration de couches (10) du deuxième type on dispose supplémentairement une couche (22) antiferromagnétique, électriquement conductrice, à proximité de la couche (20) temporairement magnétique, ou un antiferro-aimant artificiel, électriquement conductrice, à proximité de la couche (20) temporairement magnétique.

13. Procédé selon la revendication 12, **caractérisé en ce que**, les configurations de couches (8, 10) sont réalisées par le dépôt des couches.

14. Procédé selon la revendication 13, **caractérisé en ce que**, la couche (22) supplémentaire, antiferromagnétique, électriquement conductrice, est appliquée de suite sur les autres couches.

15. Procédé selon la revendication 13 ou 14, **caractérisé en ce que**, les configurations de couches (8, 10) finies, sont connectées dans un montage en pont (24).

16. Procédé selon la revendication 12 ou 13, **caractérisé en ce que**,
- les configurations de couches (8, 10) sont connectées dans le montage en pont (24), avant de finalisation
- la couche (22) antiferromagnétique, électriquement conductrice, est appliquée sur les éléments désirés du montage en pont (24).
